# EUROPEAN PATENT APPLICATION

(11) **EP 4 181 018 A1**
(43) Date of publication of application: **17.05.2023**
(21) Application number: 21208063.4
(22) Date of filing: 12.11.2021
(51) Int. Cl.: G06N 3/04, G06N 3/08, G03F 7/20

(54) **LATENT SPACE SYNCHRONIZATION OF MACHINE LEARNING MODELS FOR IN-DEVICE METROLOGY INFERENCE**

(71) Applicant: ASML Netherlands B.V., 5500 AH Veldhoven (NL)
(72) Inventor: BARBIERI, Davide, 5500 AH Veldhoven (NL); CERFONTAINE, Pascal, Aachen (DE)
(74) Representative: ASML Netherlands B.V.

(57) **Abstract**

Autoencoder models may be used in the field of lithography to estimate, infer or predict a parameter of interest (e.g., metrology metrics). An autoencoder model is trained to predict a parameter by training it with measurement data (e.g., pupil images) of a substrate obtained from a measurement tool (e.g., optical metrology tool). Disclosed are methods and systems for synchronizing two or more autoencoder models for in-device metrology. Synchronizing two autoencoder models may configure the encoders of both autoencoder models to map from different signal spaces (e.g., measurement data obtained from different machines) to the same latent space, and the decoders to map from the same latent space to each autoencoder's respective signal space. Synchronizing may be performed for various purposes, including matching a measurement performance of one tool with another tool, and configuring a model to adapt to measurement process changes (e.g., changes in characteristics of the tool) over time.

## Description

### TECHNICAL FIELD

This description relates to methods and systems for training autoencoder models for estimating manufacturing process parameters.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm, and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance.

To overcome these difficulties, sophisticated fine-tuning steps may be applied to the lithographic projection apparatus and/or design layout. These include, for example, but are not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

### SUMMARY

In some embodiments, there is provided a non-transitory computer-readable medium having instructions that, when executed by a computer, cause the computer to execute a method for synchronizing a first machine learning model with a second machine learning model to facilitate parameter prediction. The method includes: obtaining a first autoencoder model that is trained to encode a first set of inputs associated with a first lithographic process environment to a first latent space, wherein the first latent space includes a first set of outputs that has a lower dimensionality than the first set of inputs; obtaining a prediction model that is trained using reference data associated with the first latent space to predict one or more parameters associated with a lithographic process; obtaining a second autoencoder model that is trained to encode a second set of inputs associated with a second lithographic process environment to a second latent space, wherein the second latent space includes a second set of outputs that has a lower dimensionality than the second set of inputs; and synchronizing the second latent space with the first latent space to further train the second autoencoder model to facilitate parameter estimation using the prediction model.

In some embodiments, there is provided a method for synchronizing a first machine learning model with a second machine learning model to facilitate parameter prediction. The method includes: obtaining a first autoencoder model that is trained to encode a first set of inputs associated with a first lithographic process environment to a first latent space, wherein the first latent space includes a first set of outputs that has a lower dimensionality than the first set of inputs; obtaining a prediction model that is trained using reference data associated with the first latent space to predict one or more parameters associated with a lithographic process; obtaining a second autoencoder model that is trained to encode a second set of inputs associated with a second lithographic process environment to a second latent space, wherein the second latent space includes a second set of outputs that has a lower dimensionality than the second set of inputs; and synchronizing the second latent space with the first latent space to further train the second autoencoder model to facilitate parameter estimation using the prediction model.

In some embodiments, there is provided an apparatus for synchronizing a first machine learning model with a second machine learning model to facilitate parameter prediction. The apparatus includes a memory storing a set of instructions; and a processor configured to execute the set of instructions to cause the apparatus to perform a method, which includes: obtaining a first autoencoder model that is trained to encode a first set of inputs associated with a first lithographic process environment to a first latent space, wherein the first latent space includes a first set of outputs that has a lower dimensionality than the first set of inputs; obtaining a prediction model that is trained using reference data associated with the first latent space to predict one or more parameters associated with a lithographic process; obtaining a second autoencoder model that is trained to encode a second set of inputs associated with a second lithographic process environment to a second latent space, wherein the second latent space includes a second set of outputs that has a lower dimensionality than the second set of inputs; and synchronizing the second latent space with the first latent space to further train the second autoencoder model to facilitate parameter estimation using the prediction model.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figure 1 depicts a schematic overview of a lithographic apparatus, according to an embodiment.
Figure 2 depicts a schematic overview of a lithographic cell, according to an embodiment.
Figure 3 depicts a schematic representation of holistic lithography, representing a cooperation between three technologies to optimize semiconductor manufacturing, according to an embodiment.
Figure 4 illustrates an example metrology apparatus, such as a scatterometer, according to an embodiment.
Figure 5 illustrates encoder-decoder architecture, according to an embodiment.
Figure 6 illustrates encoder-decoder architecture within a neural network, according to an embodiment.
Figure 7A is a block diagram for synchronizing autoencoder models associated with two different machines (e.g., measurement tools) to match a performance of one machine with another machine, in accordance with one or more embodiments.
Figure 7B is a block diagram for synchronizing autoencoder models to adapt to process changes in a machine over time, in accordance with one or more embodiments.
Figure 8 is a flow diagram of a method for synchronizing latent spaces of autoencoder models in accordance with one or more embodiments.
Figure 9A is a flow diagram of a method of synchronizing latent spaces of two autoencoder models, in accordance with one or more embodiments.
Figure 9B is a block diagram illustrating synchronization of latent spaces of two autoencoder models, in accordance with one or more embodiments.
Figure 10A is a flow diagram of a method of synchronizing latent spaces of two autoencoder models, in accordance with one or more embodiments.
Figure 10B is a block diagram illustrating synchronization of latent spaces of two autoencoder models, in accordance with one or more embodiments.
Figure 11 is a block diagram of an example computer system, according to an embodiment.

### DETAILED DESCRIPTION

Autoencoders can be configured for use in metrology and/or other solutions for parameter inference and/or for other purposes. This deep learning model architecture is generic and scalable to an arbitrary size and complexity. Autoencoders are configured to compress a high dimensional signal (e.g., pupil images in a semiconductor manufacturing process) to a low dimensional representation of the same signal (e.g., referred to as latent space). Next, parameter inference (e.g., regression) is performed from the low-dimensional representation towards a set of known labels. By first compressing the signal, the inference problem is significantly simplified compared to performing regression on the high dimensional signal directly.

In semiconductor manufacturing, optical metrology may be used to measure critical stack parameters directly on product (e.g., patterned wafer) structures. Machine-learning (ML) methods are often applied on top of optical scatterometry data acquired using a metrology platform. These machine-learning methods conceptually amount to supervised learning approaches, e.g., learning from labeled datasets. Often, labeled datasets are created by measuring and labelling known targets in a wafer using various tools (e.g., a scanning electron microscope (SEM)). The availability of labeled dataset is limited because the SEM data is often expensive to obtain. This is partially due to the fact that the SEM measurements can be destructive to a semiconductor stack and because it is a slow metrology technique. The parameter estimation may be performed using such prediction models (e.g., supervised learning ML models), which are trained using the labeled data to predict or estimate a parameter (e.g., semiconductor manufacturing process parameters, such as an overlay) from low-dimensional data in the latent space. One of the primary challenges in performing parameter estimation using such ML models is the fact that often labeled data may be unavailable, obtaining the labeled data is resource prohibitive, or obtaining the labeled data may be invasive (e.g., may cause damage to the wafer). Accordingly, a dependance on the labeled data for performing parameter estimation may have to be minimized. Some prior parameter estimation methods may use prediction models (e.g., semi-supervised or unsupervised ML models) that may be trained without the SEM data, but they lack prediction accuracy (e.g., what the ML models learn may not match the data measured using SEM).

Conventional methods of parameter estimation fall short in various applications. For example, in an application such as tool-to-tool matching where performance of a first machine (e.g., metrology or inspection tool associated with a lithographic apparatus) has to be matched with that of a second machine, a single shared model (e.g., autoencoder model) may have to be trained with data (e.g., pupil image representative of target locations on a wafer) from multiple machines, and the same wafers may have to be measured under the different machines. Further, the prediction model may also have to be trained with reference data (e.g., labeled data) obtained for both the machines. Moreover, these conventional methods also have a restriction that the machines whose performance are to be matched to have the same exact signal space (e.g., pupils of the same size). Such methods of training the autoencoder model may be computing resource prohibitive (e.g., consumes significant time and computing resources) and may result in causing damage to the wafer due to repeated measurement of the wafer for obtaining the reference data.

In another example, autoencoder models may be configured to adapt to process change over time. In some embodiments, variation between wafers may not be caused by different measuring tools but by the wafers being produced at different points in time. Over time unobserved changes to a lithographic process environment (e.g., the lithographic apparatus, or the measuring tool), may cause the signal (e.g., pupil image) to be interpreted differently by a sensor, with regards to inferring some parameters of interest (Pol). Such changes may be referred to as process change. Conventional methods retrain a new autoencoder model on all previously acquired data every time a new wafer is measured. There are several drawbacks with such methods. First, as more and more data are acquired over time, the time required to train the autoencoder model may also increases. In addition, this may also result in a possible decay in the autoencoder model's performance (e.g., being a parametric method and hence with a finite capacity). Second, if the reference data are used for parameter inference (e.g., SEM-assisted methods), these reference data may need to be obtained for every new wafer or for every few wafers on which the next model is trained. Such methods of training the autoencoder model may be computing resource prohibitive (e.g., consumes significant time and computing resources).

Methods and systems are disclosed to at least overcome the above drawbacks. In the disclosed embodiments, autoencoder model associated with one lithographic process environment (e.g., representative of a measurement tool, product layers on the same wafer, times at which the wafer is measured using the same machine) is synchronized with that of another lithographic process environment to make the training of the autoencoder model to facilitate parameter estimation/inference in the other lithographic process environment more efficient. In some embodiments, synchronizing two autoencoder models may include synchronizing latent spaces of the two autoencoder models. For example, in a tool-to-tool matching use case, consider that a first autoencoder model is trained to encode first measurement data (e.g., a first set of inputs such as pupil images) of wafers measured using a first machine (e.g., a first lithographic process environment) to low-dimensional data (e.g., a first set of outputs) in a first latent space that is representative of the first measurement data. A prediction model associated with the first autoencoder model is also trained with reference data (e.g., labeled measurement data of the wafers obtained using other instruments (e.g., SEM)) to predict a parameter based on the first latent space. Note that while the prediction model is used for estimating a parameter, in some embodiments, the tool-to-tool matching use case may be implemented without the prediction model or without the reference data. A second autoencoder model associated with a second machine is trained to encode second measurement data (e.g., a second set of inputs such as pupil images) of wafers measured using a second machine (e.g., a second lithographic process environment) to low-dimensional data (e.g., a second set of outputs) in a second latent space that is representative of the second measurement data. The performance (e.g., measurement performance) of the second machine may be matched with the first machine by synchronizing the second latent space of the second autoencoder model with the first latent space of the first autoencoder model, which may cause the encoders of both autoencoder models to map inputs from different signal space (e.g., measurement data from different machines) to the same latent space and both decoders to map from the same latent space to each autoencoder's respective signal space. After the synchronization, the prediction model associated with the first autoencoder may also be used to perform parameter estimation based on the second latent space (e.g., since the second latent space and the first latent space are synchronized to form the same latent space).

By synchronizing the second latent space with the first latent space, a need for training the second autoencoder model with all the first measurement data used to train the first autoencoder model is eliminated, thereby minimizing an amount of computing resources consumed in training the second autoencoder model. Further, since the prediction model associated with the first autoencoder may also be used to perform parameter estimation based on the second latent space, a need for training the prediction model associated with the second autoencoder model with all the reference data used to train the prediction model associated with the first autoencoder model is eliminated. Furthermore, the synchronization eliminates the need for the same wafers to be measured by both the machines for performing the tool-to-tool matching.

Similarly, the above synchronization method may also be applied to make an autoencoder model adapt to changes in a lithographic process environment over time (e.g., changes within a machine). For example, an autoencoder model T(t), at a time t, is synchronized with (a) the most recent autoencoder model T(x) trained using the most recent measurement data (e.g., obtained until time x, where x < t) and (b) the most recent autoencoder model T(y) whose prediction model is trained using the most recent reference data (e.g., obtained until time y, where y is ≤ x < t) to adapt to the process changes over time. By synchronizing the latent space of a current auto encoder model with the latent space of the most recent auto encoder model, a need for training the current autoencoder model with all the measurement data and reference data obtained until a current time is eliminated, thereby minimizing an amount of computing resources consumed in training the current autoencoder model, and minimizing the wafer damage that may otherwise be caused in obtaining the reference data every time new wafers are measured by the machine. In some embodiments, by synchronizing the latent space, additional errors (e.g., measurement errors) that may be introduced if new reference measurements are taken using a different reference measurement machine or because of time-drift in the reference measurement process may be minimized. While the autoencoder model may have to be trained using the reference data subsequently, the frequency at which reference data may be provided to train the autoencoder model (e.g., every *n* number of models, every few minutes, hours, days, or every m wafers measured, or some other condition) may be configured by a user. However, the autoencoder may not have to be trained with the reference data every time a new wafer is measured unlike the conventional methods. Accordingly, in some embodiments, the synchronization method may be applied to match the performance of machine with another machine, of the machine with its performance in the past, and to eliminate the need to use reference data for training every time a new wafer is measured.

Note that the term autoencoder used in association with the autoencoder model may generally refer to one or more autoencoders, or one or more parts of an autoencoder, configured for partial supervised learning using a latent space for parameter estimation, and/or other operations. In addition, the various drawbacks (e.g., of prior systems) and advantages (of the synchronization of autoencoder models) described above are examples of many other possible drawbacks and advantages, and should not be considered limiting. In some embodiments, the term autoencoder may refer to "variational autoencoders," also referred to as "VAE." Further, while the description refers to autoencoders, any encoder that may be configured to compress a high dimensional signal (e.g., pupil images in a semiconductor manufacturing process) to a low dimensional representation of the same signal (e.g., referred to as latent space) may be used to implement the disclosed embodiments. Finally, although specific reference may be made in this text to the manufacture of integrated circuits, the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the method described herein may have many other possible applications in diverse fields such as language processing systems, self-driving cars, medical imaging and diagnosis, semantic segmentation, denoising, chip design, electronic design automation, etc. The present method may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "reticle," "mask," or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array.

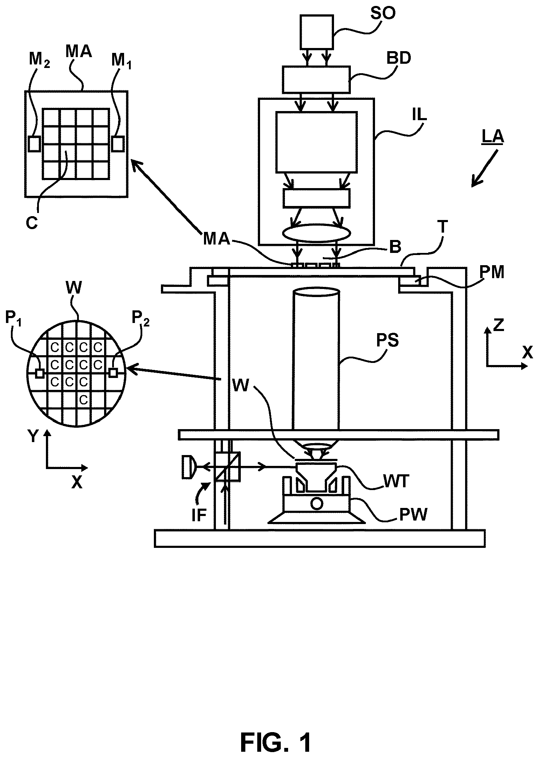

As a brief introduction, Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT configured to hold a substrate (e.g., a resist coated wafer) W and coupled to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

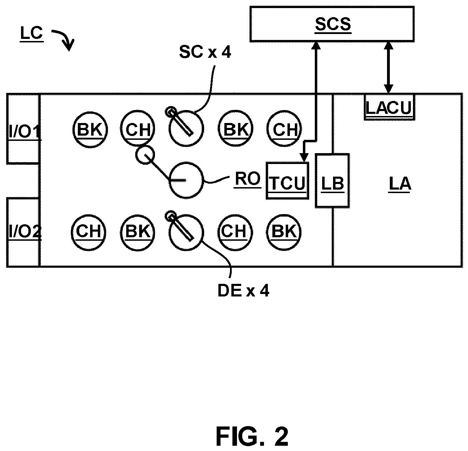

Figure 2 depicts a schematic overview of a lithographic cell LC. As shown in Figure 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g., via lithography control unit LACU.

In order for the substrates W (Figure 1) exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semilatent image (image in a resist layer after a post-exposure bake step PEB), or on a developed resist image (in which the exposed or unexposed parts of the resist have been removed), or even on an etched image (after a pattern transfer step such as etching).

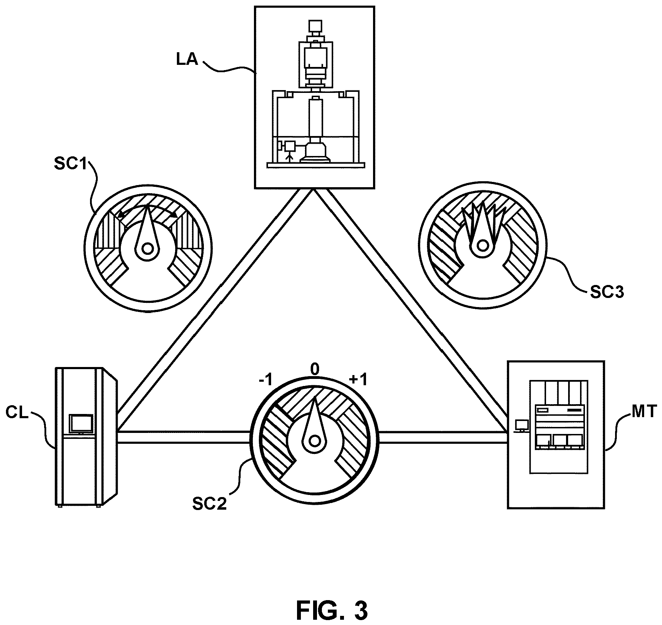

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, a scatterometer MT is an angular resolved scatterometer. In these embodiments, scatterometer reconstruction methods may be applied to the measured signal to reconstruct or calculate properties of a grating and/or other features in a substrate. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In some embodiments, scatterometer MT is a spectroscopic scatterometer MT. In these embodiments, spectroscopic scatterometer MT may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In some embodiments, scatterometer MT is a ellipsometric scatterometer. The ellipsometric scatterometer allows for determining parameters of a lithographic process by measuring scattered radiation for each polarization states. Such a metrology apparatus (MT) emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings and/or other features in a substrate, formed by a lithographic process, commonly in resist, but also after etch processes, for example. In some embodiments, one or more groups of targets may be clustered in different locations around a wafer. Typically the pitch and line-width of the structures in the gratings depend on the measurement optics (in particular the NA of the optics) to be able to capture diffraction orders coming from the metrology targets. A diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

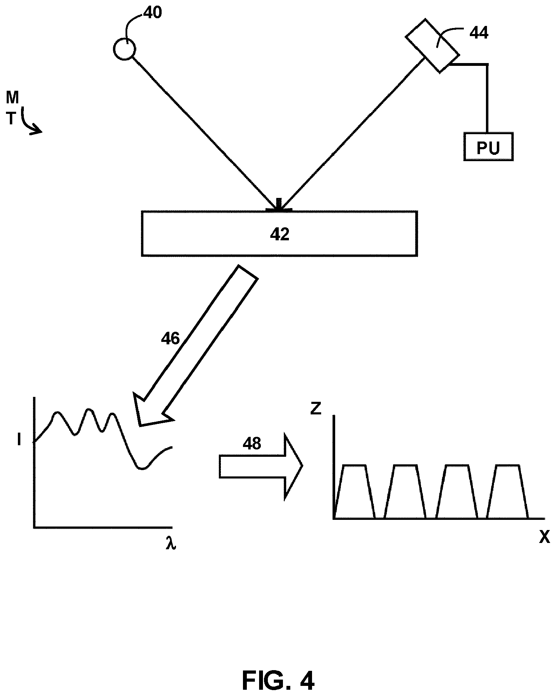

Figure 4 illustrates an example metrology apparatus (tool or platform) MT, such as a scatterometer. MT comprises a broadband (white light) radiation projector 40 which projects radiation onto a substrate 42. The reflected or scattered radiation is passed to a spectrometer detector 44, which measures a spectrum 46 (i.e. a measurement of intensity as a function of wavelength) of the specular reflected radiation. From this data, the structure or profile giving rise to the detected spectrum may be reconstructed 48 by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer, for example.

It is often desirable to be able computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation and/or modeling can be used to determine one or more metrology metrics (e.g., performing overlay and/or other metrology measurements), configure one or more features of the patterning device pattern (e.g., performing optical proximity correction), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, inspection operation variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection and/or an inspection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

In some embodiments, the disclosed embodiments may include an empirical model that performs one or more of the operations described herein. The empirical model may predict outputs based on correlations between various inputs (e.g., one or more characteristics of a pupil image, one or more characteristics of a complex electric field image, one or more characteristics of a design layout, one or more characteristics of the patterning device, one or more characteristics of the illumination used in the lithographic process such as the wavelength, etc.).

As an example, the empirical model may be a parameterized model and/or other models. The parameterized model may be an ML model and/or any other parameterized model. In some embodiments, an ML model (for example) may be and/or include mathematical equations, algorithms, plots, charts, networks (e.g., neural networks), and/or other tools and ML model components. For example, an ML model may be and/or include one or more neural networks (e.g., neural network blocks) having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be selflearning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be freer flowing, with connections interacting in a more chaotic and complex fashion. In some embodiments, the intermediate layers of the one or more neural networks include one or more convolutional layers, one or more recurrent layers, and/or other layers.

The one or more neural networks may be trained (i.e., whose parameters are determined) using a set of training data (e.g., ground truths). The training data may include a set of training samples. Each sample may be a pair comprising an input object (typically an image, a measurement, a tensor or vector which may be called a feature tensor or vector) and a desired output value (also called the supervisory signal). A training algorithm analyzes the training data and adjusts the behavior of the neural network by adjusting the parameters (e.g., weights of one or more layers) of the neural network based on the training data. For example, given a set of N training samples of the form {(x₁,y₁), (x₂,y₂), ... , (x_{N},y_{N})} such that xᵢ is the feature tensor / vector of the i-th example and yᵢ is its supervisory signal, a training algorithm seeks a neural network g: X → Y, where X is the input space and Y is the output space. A feature tensor / vector is an n-dimensional tensor / vector of numerical features that represent some object (e.g., a complex electric field image). The tensor / vector space associated with these vectors is often called the feature or latent space. After training, the neural network may be used for making predictions using new samples.

As described herein, a synchronization of latent spaces of two autoencoder models is disclosed. In the disclosed embodiments, an autoencoder model associated with one lithographic process environment (e.g., representative of a measurement tool, product layers on the same wafer, times at which the wafer is measured using the same machine) is synchronized with that of another lithographic process environment to make the training of the autoencoder model to facilitate parameter estimation/inference in the other lithographic process environment more efficient. The autoencoder model includes one or more parameterized models (e.g., ML models such as a neural network) that use an encoder-decoder architecture, or other models. In the middle (e.g., middle layers) of the model (e.g., a neural network), the model formulates a low-dimensional encoding (e.g., in a latent space) that encapsulates information in an input to the model (e.g., a pupil image and/or other input associated with a pattern or other features of a semiconductor manufacturing or metrology (and/or other sensing) process). The autoencoder model leverages the low dimensionality and compactness of the latent space to make parameter estimations and/or predictions.

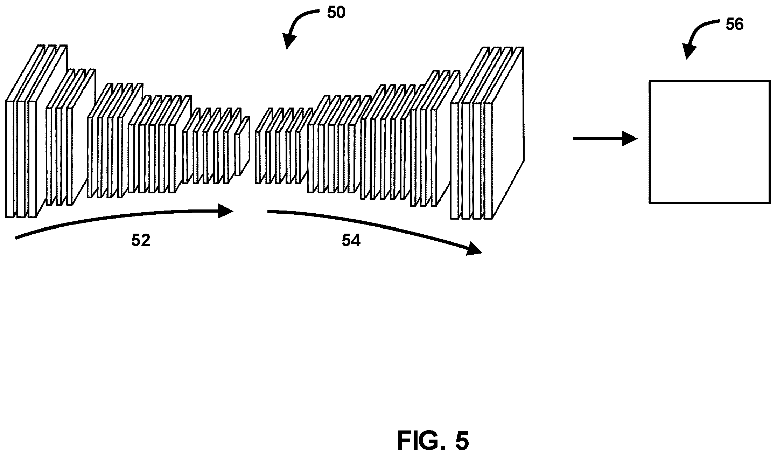

By way of a non-limiting example, Figure 5 illustrates general encoder-decoder architecture 50. Encoder-decoder architecture 50 has an encoding portion (an encoder 52) and a decoding portion (a decoder 54). In the example shown in Figure 5, encoder-decoder architecture 50 may output predicted pupil images 56 and/or other outputs, for example.

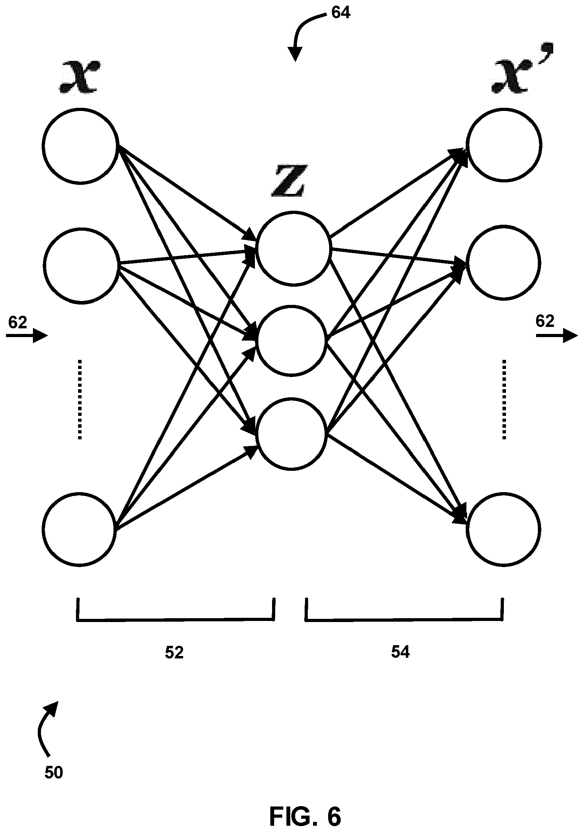

By way of another non-limiting example, Figure 6 illustrates encoder-decoder architecture 50 within a neural network 62. In some embodiments, an autoencoder model described herein may be implemented using the encoder-decoder architecture 50. Encoder-decoder architecture 50 includes encoder 52 and decoder 54. In Figure 6, x represents encoder input (e.g., an input pupil image and/or extracted features of the input pupil image) and x' represents decoder output (e.g., a predicted output image and/or predicted features of an output image). In some embodiments, x' may represent an output from an intermediate layer of neural network (in comparison to a final output of the overall model), for example, or other outputs. In Figure 6, z represents the latent space 64 or a low-dimensional encoding (tensor/vector). In some embodiments, z is, or is related to, a latent variable. To summarize briefly, the encoder 52 encodes the input x to low-dimensional data z in a latent space 64, and the decoder 54 decodes the low-dimensional data z to output images (e.g., predicted pupil images). In some embodiments, an autoencoder model is trained by comparing the outputs (e.g., predicted pupil images) to corresponding inputs (e.g., pupil images obtained using a measuring tool in a lithographic apparatus), and adjusting a parameterization of the encoder or decoder (e.g., weights and biases) to reduce or minimize a difference between an output and a corresponding input. After the difference is minimized, the autoencoder model is considered to be trained, and the trained autoencoder may be used to encode any set of inputs to low-dimensional data in a latent space.

In some embodiments, the low-dimensional encoding z represents features of an input (e.g., a pupil image). The features of the input may be considered key or critical features of the input. Features may be considered key or critical features of an input because they are relatively more predictive than other features of a desired output or have other characteristics, for example. The features (dimensions) represented in the low-dimensional encoding may be predetermined (e.g., by a programmer at the creation of the autoencoder model), determined by prior layers of a neural network, adjusted by a user via a user interface associated with a system, or may be determined by other methods. In some embodiments, a quantity of features (dimensions) represented by the low-dimensional encoding may be predetermined (e.g., by the programmer at the creation of the autoencoder model), determined based on output from prior layers of the neural network, adjusted by the user via the user interface associated with a system described herein, or determined by other methods. In some embodiments, some of the features in the latent space may be referred to as "abstract latent features" whose meaning with respect to the inputs is unknown and some other features in the latent space may be referred to as "physically derived latent features" which are observable/measurable features with respect to the input.

It should be noted that even though a machine learning model, a neural network, and/or encoder-decoder architecture are mentioned throughout this specification, a machine learning model, a neural network, and encoder-decoder architecture are just examples, and the operations described herein may be applied to different parameterized models.

In general, autoencoder models can be adapted for use in metrology and/or other solutions for parameter inference or for other purposes. Inference may comprise estimating parameters of interest from data or other operations. For example, this may comprise finding a latent representation in a forward way by evaluating an encoder, or in an inverse way, by solving the inverse problem using a decoder. After finding the latent representation, parameters of interest may be found by evaluating a prediction model. Additionally, the latent representation provides a set of outputs (because one can evaluate a decoder, given a latent representation), which can be compared to the input data to the encoder, for example. In essence, within the present context, prediction, inference or estimation (of parameters of interest) can be used interchangeably. Autoencoder model architecture is generic and scalable to an arbitrary size and complexity. Autoencoder models are configured to compress a high-dimensional signal (input such as pupil image) to an efficient low-dimensional representation of the same signal. Parameter inference (e.g., which can include regression or other operations) may be performed from the low-dimensional representation towards a set of known labels. Labels may be the "references" used in supervised learning. Within this context, this may mean either external references one would like to reproduce, or a design of carefully crafted metrology targets. Measuring carefully crafted metrology target may include measuring known targets that have known (absolute/relative) properties (e.g., overlay and/or other properties, for example). By first compressing the (input) signal, the inference problem is significantly simplified compared to performing regression and/or other operations on the high dimensional signal directly.

The following describes an application of an autoencoder model. As described above, the autoencoder model may be trained to encode an input signal (e.g., a pupil image) to low-dimensional data (e.g., features) in a latent space that is representative of the input. A prediction model associated with the autoencoder may be trained to predict a parameter of interest from the low-dimensional data in the latent space. Optical metrology platforms (e.g., apparatuses, tools, etc.) are often configured to infer physical parameters of the structures on a semiconductor wafer, from corresponding pupil images. In some embodiments, a number of inputs (e.g., pupil images) are encoded by the autoencoder model to yield a mapping from pupils (or whatever input is used) to an arbitrary, low-dimensional data in a latent space. Next, the prediction model is trained using reference data having labeled pupils to learn a mapping from the low-dimensional data in the latent space to the parameters of interest. The pupils in the reference data are acquired and labeled using either self-reference targets or using critical dimension SEM data. Note that the availability of labeled pupils is limited because the SEM data is often expensive to obtain. This is partially due to the fact that the SEM measurements can be destructive to a semiconductor stack and because it is a slow metrology technique. As a result of this only a limited, yet expensive, training data set is available. By using a latent space to do the parameter inference, rather than the high-dimensional pupil images as used in conventional methods, the low-dimensional or compressed data may be used to further analyze pupil data for parameter estimation in a more efficient manner, and in some embodiments, the need for a significant number of training pupil images may be eliminated, thereby minimizing the damage caused to the wafer being measured (e.g., in some embodiments, the entire wafer, and not just the locations being measured with SEM, may be damaged). This can be performed using a reduced number of targets, because the mapping is simpler (lower in dimensionality), which helps mitigate the problems described above. After the prediction model is trained, the prediction model may be used to estimate one or more parameters for any given latent space. In some embodiments, the prediction model may be trained using semi-supervised or unsupervised ML methods. Additional detail with reference to training the autoencoder model or the prediction model for parameter inference is discussed in the European Patent Application No. EP20217883.6, titled "Modular Autoencoder Model For Manufacturing Process Parameter Estimation", which is hereby incorporated by reference in its entirety. Further, in some embodiments, some parameters (e.g., overlay) may be estimated directly from the latent space in which case the prediction model may not be used for the estimation.

As described above, process information (e.g., images, measurements, process parameters, metrology metrics, etc.) may be used to guide various manufacturing operations. Utilizing the relatively lower dimensionality of a latent space to predict and/or otherwise determine the process information may be faster, more efficient, require fewer computing resources, and/or have other advantages over prior methods for determining process information.

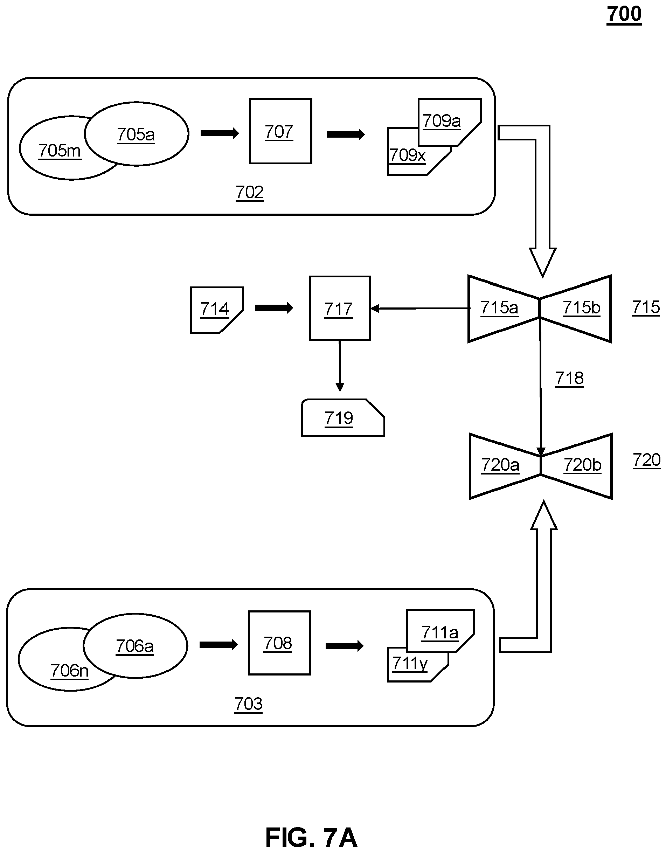

Figure 7A is a block diagram for synchronizing autoencoder models associated with two different machines (e.g., measurement tools) to match a performance of one machine with another machine, in accordance with one or more embodiments. In some embodiments, various types of apparatuses, machines, tools, or platforms may be used to obtain various measurement data (e.g., metrology metrics, or semiconductor manufacturing process related data) associated with a patterned substrate. Optical metrology platforms (e.g., apparatuses, tools, etc. such as the one shown in Figure 4) are often configured to infer physical parameters of the structures on a semiconductor wafer, from corresponding pupil images. For example, in semiconductor manufacturing, optical metrology may be used to measure critical stack parameters directly on product (e.g., patterned wafer) structures. For example, in optical metrology, features on a wafer are excited using polarized light and the response (raw scattered light intensity and/or phase) is used to infer/measure the parameters of interest of the given features. A model (e.g., ML model) associated with the optical metrology platform is usually trained with the pupil images or other optical scatterometry data acquired using the optical metrology platform and then used for inference (e.g., estimating or predicting parameters of interest, such as an overlay).

In some embodiments, an entity may use multiple tools or machines for obtaining the measurement data, and a model created for one machine is trained on the measurement data (e.g., pupil images that are representative of semiconductor manufacturing process parameters) obtained from a single machine. In some embodiments, the entity may want a model that predicts parameters of interest with the same accuracy for measurement data obtained using any of the multiple tools. Typically, this may not be the case because often there are differences in the sensors, hardware, or other characteristics of these machines, which may result in the models with different machines having different prediction accuracy. So, tool-to-tool matching refers to solving a problem of finding a model that results in a good predictive performance across several tools. In some embodiments, matching a performance of one tool with another tool may mean matching the prediction accuracy of a certain parameter (e.g., overlay or other semiconductor manufacturing process related parameter) of a model associated with one machine with that of another machine. In some embodiments, the performance of a second tool may be matched with the performance of a first tool by synchronizing a second model associated with the second tool with a first model associated with the first tool (which is described below).

In the example 700, a first autoencoder model 715 is trained on measurement data associated with a first lithographic process environment 702 and a second autoencoder model 720 is trained on measurement data associated with a second lithographic process environment 703. For example, the first autoencoder model 715 is trained on a first set of inputs 709a - 709x (e.g., pupil images associated with target locations on one or more substrates 705a - 705m, other input associated with a pattern, features of a semiconductor manufacturing, or metrology process data) obtained using a first measurement tool or machine 707 (e.g., measurement tool associated with a lithographic apparatus used to print a target pattern on the substrates 705) to generate a first latent space having low-dimensional data that is representative of the first set of inputs 709. A first prediction model 717 associated with the first autoencoder model 715 may be trained to estimate a parameter 719 based on the first latent space. For example, the first prediction model 717 may be trained using reference data 714 (e.g., labeled data), which may include labeled pupils associated with the substrates 705 with the labels being semiconductor manufacturing process parameters, such as overlay, tilt, etc. Note that while the following paragraphs describe using the first prediction model 717 for the parameter estimation, the parameter estimation may also be performed without the first prediction model 717 (e.g., some parameters such as an overlay may be directly obtained from the first latent space).

Similarly, the second autoencoder model 720 is trained on a second set of inputs 711a - 711y (e.g., pupil images associated with target locations on one or more substrates 706a - 706n, other input associated with a pattern, features of a semiconductor manufacturing, or metrology process) obtained using a second measurement tool or machine 708 (e.g., measurement tool associated with a lithographic apparatus used to print a target pattern on the substrates 706) to generate a second latent space having low-dimensional data that is representative of the second set of inputs 711. A second prediction model (not shown) associated with the second autoencoder model 720 may be trained to estimate a parameter based on the second latent space. For example, the second prediction model may be trained using reference data (e.g., labeled data), which may include labeled pupils associated with the substrates 706 with the labels being semiconductor manufacturing process parameters, such as overlay, tilt, etc. In some embodiments, the first autoencoder model 715, the first prediction model 717, the second autoencoder model 720 and the second prediction model may be trained as described above.

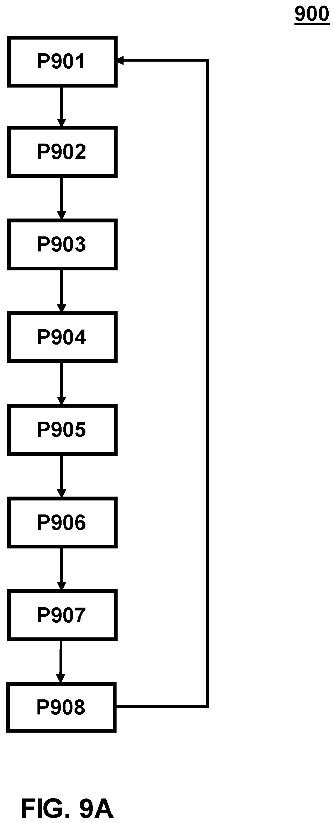

In some embodiments, a performance (e.g., measurement performance) of one machine may be matched with the performance of another machine by synchronizing the latent spaces of the autoencoders associated with the machines. For example, if the performance of the second machine 708 is to be matched with the performance of the first machine 707, the second latent space of the second autoencoder model 720 may be synchronized 718 with the first latent space of the first autoencoder model 715. In some embodiments, a signal space is representative of, or a function of, various characteristics of a machine that is used to obtain the inputs and the signal space may be different for different machines. For example, the measurement data obtained from a first machine (e.g., first signal space) may be different from that of a second machine (e.g., second signal space) for the same target location in a substrate and this may be due to the characteristics of the machines or the process employed in obtaining the measurement data. In some embodiments, synchronizing two latent spaces may mean that the encoders of both autoencoder models may map inputs from different signal space (e.g., measurement data from different machines) to the same latent space, and both decoders may map from the same latent space to each autoencoder's respective signal space, thus matching the performance of one tool with another tool. Additional details with respect to synchronization 718 are described at least with reference to Figures 9A-10B.

After the second autoencoder model 720 is synchronized with the first autoencoder model 715, the prediction model 717 associated with the first autoencoder model 715 may be used to predict a parameter based on the second latent space (e.g., since the second latent space and the first latent space are synchronized to form the same latent space). For example, the second autoencoder model 720 may encode a given set of inputs (e.g., measurement data such as pupil images associated with a given substrate) obtained using the second machine 708 to a set of outputs (e.g., low-dimensional data) in a second latent space. The set of outputs may then be provided to the prediction model 717 to predict one or more parameters. That is, for a set of inputs obtained using the second machine 708, parameter inference is performed based on a performance associated with the first machine 707.

In some embodiments, by synchronizing the second autoencoder model 720 with the first autoencoder model 715 a training of the second autoencoder model 720 to perform parameter estimation with the performance of the first machine 707 is significantly improved. For example, by synchronizing the second latent space with the first latent space, a need for training the second autoencoder model 720 with all the measurement data (e.g., first set of inputs 709) that is used to train the first autoencoder model 715 is eliminated, thereby minimizing an amount of computing resources consumed in training the second autoencoder model 720. Further, since the prediction model 717 associated with the first autoencoder model 715 may also be used to perform parameter estimation based on the second latent space of the second autoencoder model 720, a need for training the prediction model associated with the second autoencoder model 720 with all the reference data 714 used to train the prediction model 717 associated with the first autoencoder model 715 is eliminated. Furthermore, the synchronization eliminates the need for the machines to measure the same wafers for matching the performance of the machines. In some embodiments, while the need for measuring the same wafers is eliminated the wafers measured by the different machine may have to be of the same architecture.

In some embodiments, the differences in performance between two tools, and therefore, a difference between autoencoder models trained on measurement data from different tools, may be mostly due to differences in hardware, sensory or other characteristics of the tools. So, if the same procedure on two tools gives different performances, and thus one is worse than the other, then this may be because one tool fails to extract a reasonable signal from the pupils. The synchronization method may abstract out the pupils (e.g., remove tool-dependent signal) to prevent any tool dependent signal from being included in the latent space, since the latent space, if truly shared, has only features that are common for data from both tools. So, if the latent spaces match (which is what the synchronization method does), then consequently the two models may extract the same signal and thus be able to match their prediction performance. To put it in another way, for example, unless there is a broken component in one of the tools, the prediction performance of either tool should be the same, and if they are not, then it may be because of some slight miscalibration (for example) in one of the two tools. The synchronization process facilitates a model associated with a lower performance (e.g., the second autoencoder model 720) to use what it learned from a model associated with the properly calibrated machine (e.g., the first autoencoder model 715) to better discern the added noise in the miscalibrated tool. The synchronization process analyzes data from both tools (e.g., latent spaces) and tries to remove anything that is unique to a particular machine (e.g., added noise, which may be a pattern in the latent space data that affects the accuracy of the predictions), thereby matching the performance. Additional details with respect to synchronization of latent spaces are described at least with reference to Figures 9A-10B below.

While the foregoing paragraphs describe synchronizing two autoencoder models for matching a performance of the machines, the synchronization may also be applicable matching autoencoder models for different products or product layers that are measured in the same machine. For example, the first autoencoder model 715 may be trained on the first set of inputs 709 that are related to a first layer of the target pattern on the substrates 705 (e.g., a first 3D NAND layer of a memory) and the second autoencoder model 720 may be trained on the second set of inputs 711 that are related to a second layer of the target pattern on the substrates 705 (e.g., a second 3D NAND layer of a memory). By synchronizing the two autoencoder models, the measurement performance between different layers of the target pattern may be matched for a given machine.

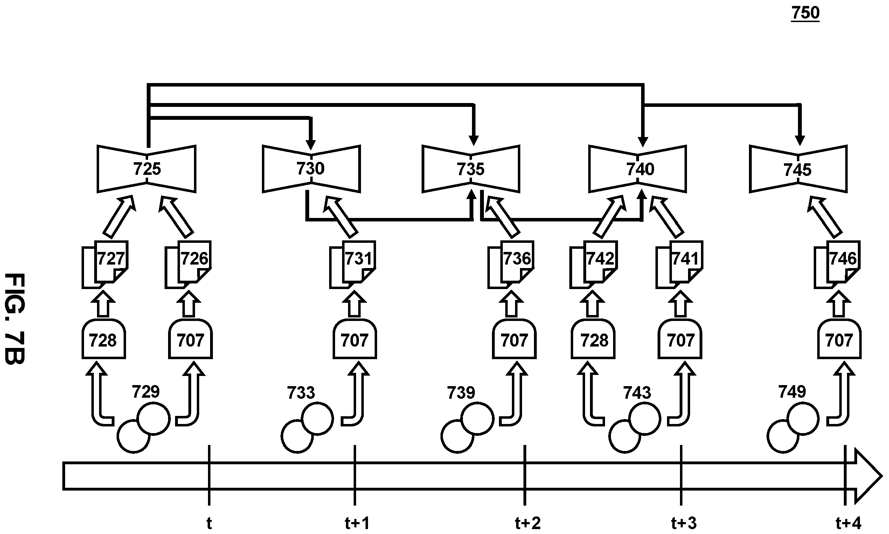

Figure 7B is a block diagram for synchronizing autoencoder models to adapt to process changes (e.g., in a machine) over time, in accordance with one or more embodiments. In the example 750, a first autoencoder model 725 is trained at time, t, on a first set of inputs 726 (e.g., pupil images associated with target locations on one or more substrates 729, other input associated with a pattern, features of a semiconductor manufacturing, or metrology process data) obtained using the first machine 707 until time t to generate low-dimensional data in a first latent space. A first prediction model associated with the first autoencoder model 725 may be trained to estimate a parameter 719 based on the first latent space. For example, the first prediction model may be trained using reference data 727 (e.g., labeled data obtained using SEM 728), which may include labeled pupils associated with the substrates 729, with the labels being semiconductor manufacturing process parameters, such as overlay, tilt, etc. A second autoencoder model 730 may be trained at a time, *t* +1, on a second set of inputs 731 (e.g., pupil images associated with target locations on one or more substrates 733, other input associated with a pattern, features of a semiconductor manufacturing, or metrology process data) obtained using the first machine 707 from time *t* to *t* +1 to generate low-dimensional data in a second latent space. The second autoencoder model 730 may be configured to adapt to any process change (e.g., changes to any characteristics of the first machine 707 such as changes to optics of the first machine 707 since time t) by synchronizing the second autoencoder model 730 with the most recently trained autoencoder model and the most recent autoencoder model to be trained with the reference data. In the example 750, the most recently trained autoencoder model and the most recent autoencoder model to be trained with the reference data relative to the second autoencoder model 730 is the first autoencoder model 725. Accordingly, the second latent space of the second autoencoder model 730 is synchronized with the first latent space of the first autoencoder model 725 to program the second autoencoder model 730 to adapt to any process change.

Similarly, a third autoencoder model 735 may be trained at a time, t + 2, on a third set of inputs 736 (e.g., pupil images associated with target locations on one or more substrates 739, other input associated with a pattern, features of a semiconductor manufacturing, or metrology process data) obtained using the first machine 707 from time *t* + 1 to *t* + 2 to generate low-dimensional data in a third latent space. The third autoencoder model 735 may be configured to adapt to any process change (e.g., changes to any characteristics of the first machine 707 such as changes to optics of the first machine 707 since time t + 1) by synchronizing the third autoencoder model 735 with the most recently trained autoencoder model and the most recent autoencoder model to be trained with the reference data. In the example 750, the most recently trained autoencoder model relative to the third autoencoder model 735 is the second autoencoder model 730 and the most recent autoencoder model to be trained with the reference data is the first autoencoder model 725. Accordingly, the third latent space of the third autoencoder model 735 is synchronized with the second latent space of the second autoencoder model 730 and the first latent space of the first autoencoder model 725 to program the second autoencoder model 730 to adapt to any process change since time t.

By synchronizing the latent space of the current auto encoder model with the latent spaces of the most recently trained auto encoder model and the most recent autoencoder model to be trained with the reference data, a need for training the current autoencoder model with all the measurement data and reference data obtained until a current time is eliminated, thereby minimizing an amount of computing resources consumed in training the current autoencoder model and minimizing the wafer damage that may otherwise be caused in obtaining the reference data every time new substrates are measured by the first machine 707. For example, by synchronizing the third latent space of the third autoencoder model 735 with the latent spaces of the second autoencoder model 730 and the first autoencoder model 725, a need for training the third autoencoder model 735 with all the measurement data and reference data obtained until a current time (e.g., first set of inputs 726 and second set of inputs 731, and reference data of substrates 733 and 729) is eliminated.

The reference data may not have to be provided for every new autoencoder model that is trained. The synchronization of the latent space may be enough to ensure that the mapping of the prediction model (e.g., the first prediction model 717) of the most recent autoencoder model to use the reference data may still be used on new autoencoder models without the need for the mapping to be updated. While the autoencoder model may have to be trained using the reference data subsequently, the frequency at which reference data may be provided to train the new autoencoder model (e.g., every *n* number of models, every few minutes, hours, days, or every *m* wafers measured, or some other condition) may be configured by a user. For example, key performance indicators (KPI) may be defined for measuring how well aligned the latent spaces of two autoencoder models are and when the KPIs indicate that the latest model is diverging from the last model beyond a specified threshold, new reference data may be provided to the latest autoencoder model. In some embodiments, the frequency at which the reference data is provided to the autoencoder model may be initially high and may decrease over time (e.g., since the synchronization may not synchronize the latent spaces completely and latent spaces may shift over time).

As shown in Figure 7B, for example, a fourth autoencoder model 740 may be trained at a time, t + 3, on a fourth set of inputs 741 (e.g., pupil images associated with target locations on one or more substrates 743, other input associated with a pattern, features of a semiconductor manufacturing, or metrology process data) obtained using the first machine 707 from time *t* + 2 to *t* + 3 to generate low-dimensional data in a fourth latent space. The fourth autoencoder model 740 may be configured to adapt to any process change (e.g., changes to any characteristics of the first machine 707 such as changes to optics of the first machine 707 since time t + 2) by synchronizing the fourth autoencoder model 740 with the most recently trained autoencoder model (e.g., the third autoencoder model 735) and the most recent autoencoder model to be trained with the reference data (e.g., the first autoencoder model 725). In some embodiments, a condition for providing the new reference data may also be satisfied. For example, a user may determine or one of the KPIs may indicate that the fourth autoencoder model 740 is diverging from the third autoencoder model 735 or the first autoencoder model 725 beyond a specified threshold. Accordingly, a prediction model associated with the fourth autoencoder model 740 may be trained with new reference data 742 (e.g., labeled data obtained from the SEM 728 for substrates 743 measured between time t+2 and t+3). The next autoencoder model at a time *t* + 4, e.g., a fifth autoencoder model 745, may be trained at a time, *t* + 4, on a fifth set of inputs 746 (e.g., pupil images associated with target locations on one or more substrates 749, other input associated with a pattern, features of a semiconductor manufacturing, or metrology process data) obtained using the first machine 707 from time *t* + 3 to *t* + 4 to generate low-dimensional data in a fifth latent space. The fifth autoencoder model 745 may be configured to adapt to any process change (e.g., changes to any characteristics of the first machine 707 such as changes to optics of the first machine 707 since time t + 3) by synchronizing the fifth autoencoder model 745 with the most recently trained autoencoder model and the most recent autoencoder model to be trained with the reference data. For example, the fifth autoencoder model 745 may be trained by synchronizing the fifth latent space with the fourth latent space of the fourth autoencoder model 740 since the fourth autoencoder model 740 is the most recently trained autoencoder model and the most recent autoencoder model to be trained with the reference data (e.g., reference data 742) relative to the fifth autoencoder model 745. Thus, a new autoencoder model may be programmed to adapt to process change over time by synchronizing the new autoencoder model with the most recently trained autoencoder model and the most recent autoencoder model to be trained with the reference data for a given machine.

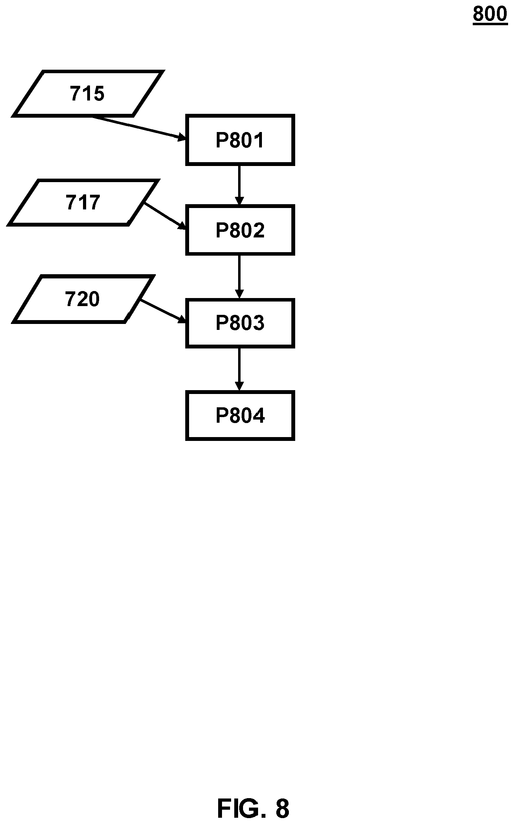

Figure 8 is a flow diagram of a method 800 for synchronizing latent spaces of autoencoder models in accordance with one or more embodiments. At process P801, a first autoencoder model that is trained to encode a first set of inputs associated with a first lithographic process environment to a first latent space is obtained. For example, the first autoencoder model may be the first autoencoder model 715 and the first lithographic process environment may be representative of the first machine 707 used to obtain the first set of inputs 709 (e.g., pupil images associated with target locations on one or more substrates 705, other input associated with a pattern, features of a semiconductor manufacturing, or metrology process data). In another example, the first autoencoder model may be the first autoencoder model 725 and the first lithographic process environment may be representative of a time t when the first set of inputs 726 (e.g., pupil images associated with target locations on one or more substrates 729, other input associated with a pattern, features of a semiconductor manufacturing, or metrology process data) are obtained from the first machine 707. The first autoencoder model may be trained to encode the first set of inputs to a first set of outputs in the first latent space. The first set of outputs may have a lower dimensionality than the first set of inputs and may include features that are representative of the first set of inputs.

At process P802, a prediction model that is trained to predict one or more parameters associated with a lithographic process based on the first latent space is obtained. For example, the prediction model may include prediction model 717 associated with the first autoencoder model 715. The prediction model 717 may be trained using reference data to learn a mapping from the first latent space to one or more parameters (e.g., semiconductor manufacturing process parameters, such as overlay, tilt, etc.). For example, the first prediction model 717 may be trained using reference data 714 (e.g., labeled data), which may include labeled pupils associated with the substrates 705 and set of outputs from the first latent space for corresponding pupils, with the labels being semiconductor manufacturing process parameters. In some embodiments, the reference data may be obtained using a SEM.

At process P803, a second autoencoder model that is trained to encode a second set of inputs associated with a second lithographic process environment to a second latent space is obtained. For example, the second autoencoder model may be the second autoencoder model 720 and the second lithographic process environment may be representative of the second machine 708 used to obtain the second set of inputs 711 (e.g., pupil images associated with target locations on one or more substrates 706, other input associated with a pattern, features of a semiconductor manufacturing, or metrology process data). In another example, the second autoencoder model may be the second autoencoder model 730 and the second lithographic process environment may be representative of a time t + 1 when the second set of inputs 731 (e.g., pupil images associated with target locations on one or more substrates 733, other input associated with a pattern, features of a semiconductor manufacturing, or metrology process data) are obtained from the first machine 707. The second autoencoder model may be trained to encode the second set of inputs to a second set of outputs in the second latent space. The second set of outputs may have a lower dimensionality than the second set of inputs and may include features that are representative of the second set of inputs.

At process P804, the second autoencoder model is synchronized with the first autoencoder model. For example, the second autoencoder model 720 may be synchronized with the first autoencoder model 715 to match a performance (e.g., measurement performance) of the second machine 708 with the performance of the first machine 707. In some embodiments, the second autoencoder model is synchronized with the first autoencoder model by synchronizing the second latent space with the first latent space to further train the second autoencoder model to facilitate parameter estimation using the performance of the first autoencoder model. In some embodiments, synchronizing two latent spaces may mean that the encoders of both autoencoder models may map inputs from different signal space (e.g., measurement data from different machines) to the same latent space, and both decoders may map from the same latent space to each autoencoder's respective signal space, thus matching the performance of one tool with another tool. After the second autoencoder model 720 is synchronized with the first autoencoder model 715, the prediction model 717 associated with the first autoencoder model 715 may be used to predict a parameter based on the second latent space (e.g., since the second latent space and the first latent space are synchronized to form the same latent space). For example, the second autoencoder model 720 may encode a given set of inputs (e.g., pupil images associated with a given substrate) obtained using the second machine 708 to a set of outputs (e.g., low-dimensional data) in a second latent space. The set of outputs may then be provided to the prediction model 717 to predict one or more parameters. That is, for a set of inputs obtained using the second machine 708, parameter inference is performed based on a performance associated with the first machine 707. Additional details of synchronization are described with reference to Figures 9A-10B below.

In some embodiments, the estimated parameter (e.g., an overlay) may be used to monitor or adjust one or more semiconductor manufacturing process parameters for printing a target pattern on a substrate so that a yield of manufacturing process is improved. For example, if the overlay is not as expected, one or more semiconductor manufacturing process parameters (such as tilt, level, height of a substrate holder or other patterning process parameter) may be adjusted based on the determined overlay, and a patterning step may be performed based on the adjusted semiconductor manufacturing process parameters to print a pattern on a substrate.

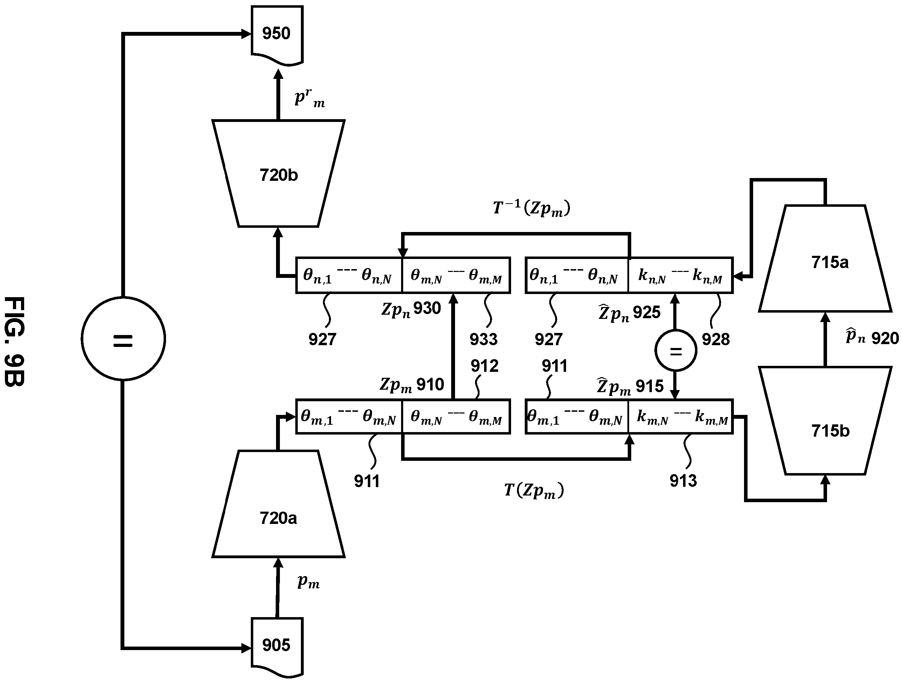

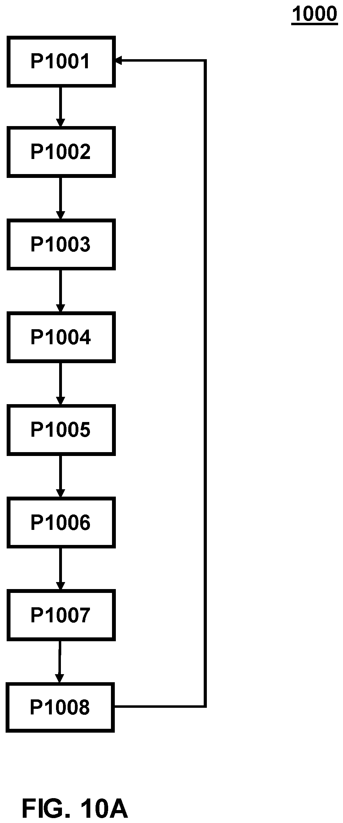

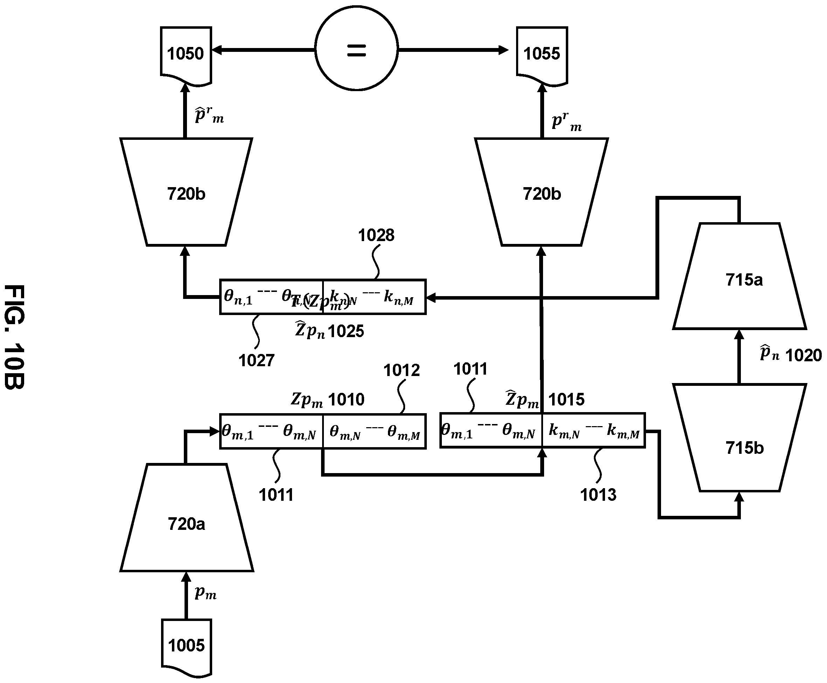

The following paragraphs describe two different methods of synchronizing the latent spaces of autoencoder models. For example, a first method 900 is described in reference to Figures 9A and 9B and a second method 1000 is described with reference to Figures 10A and 10B.

Figure 9A is a flow diagram of a first method 900 of synchronizing latent spaces of two autoencoder models, in accordance with one or more embodiments. Figure 9B is a block diagram illustrating synchronization of latent spaces of two autoencoder models, in accordance with one or more embodiments. In some embodiments, the first method 900 is a method of synchronizing a second latent space associated with a second autoencoder model 720 with the first latent space of the first autoencoder model 715. At process P901, a second set of inputs 905 *(pₘ)* are provided to a second encoder 720a associated with the second autoencoder model 720. In some embodiments, the second set of inputs 905 may include pupil images associated with target locations on one or more substrates, such as substrates 706, other input associated with a pattern on the substrates, features of a semiconductor manufacturing, or metrology process data. In some embodiments, the second set of inputs 905 may be obtained using a measurement tool such as the second machine 708.

At process P902, the second set of inputs 905 are encoded by the second encoder 720a to a second set of outputs 910 *(zpₘ)* in a second latent space of the second autoencoder model 720. For example, the encoding function of the second encoder 720a may be represented as *f*ₘ, where m is indicative of a second lithographic process environment or a second signal space, and the second set of outputs 910 may be expressed as *zpₘ=fₘ(pₘ).* In some embodiments, the second set of outputs 910 has a lower dimensionality than the second set of inputs 905. In some embodiments, the second set of outputs 910 include different types of features. For example, the second set of outputs 910 includes abstract latent features 911 (e.g., θ_{m,1} ... θ_{m,N}) and physically derived latent features 912 (e.g., θ_{m,N+1} ... θ_{m,M}). In some embodiments, abstract latent features 911 may be the features whose meaning may be unknown, and physically derived latent features 912 may include observable features (e.g., semiconductor manufacturing process parameters, such as overlay) that may be related to the second set of inputs 905.

At process P903, a transformation function (T) is applied to the second set of outputs 910 to generate a first adjusted set of outputs 915 *(z'pₘ),* which may be expressed as *z'pₘ = T(zpₘ)*)*.* In some embodiments, the transformation function sets the physically derived latent features 912 to a first constant value, thereby generating transformed physically derived latent features 913 in the first adjusted set of outputs 915. The transformation function may be differentiable or not. For example, a scenario with the transformation function being not differentiable is expected to be more robust with changes in observed ranges of the ground truth quantities observed in the sampled data for the physically derived latent features. In the case where the transformation function is differentiable, the physically derived latent features 912 from the second set of outputs 910 may be copied into a second adjusted set of outputs 930 *(zpₙ)* (e.g., via inverse transformation function, and gradients for these entries would thus backpropagate through the second encoder 720a). However, an arbitrary transformation function may be used. For example, the transformation function may set overlay values in the transformed physically derived latent features 913 to "0", thus the domain-transfer between the latent spaces would be performed on "0" overlay pupils, and the optional constraint described in process P908 would enforce matching zero-overlays in pupil space for the two encoder-decoder pairs.

At process P904, the first adjusted set of outputs 915 is decoded to a third set of inputs 920 *(p'ₙ)* using the first decoder 715b of the first autoencoder model 715. For example, decoding function of the first decoder 715b may be represented as *gₙ* in which *n* is indicative of a first lithographic process environment or a first signal space. For example, the newly derived data in the second latent space (e.g., the first adjusted set of outputs 915, *z'pₘ)* is decoded as an equivalent pupil *p'ₙ* from the first decoder 715b (process-translation) to a first signal space, hence *p'ₙ = gₙ (z'pₘ).*

At process P905, the third set of inputs 920 is encoded to a third set of outputs 925, *z'pₙ,* in the first latent space using the first encoder 715a of the first autoencoder model 715. The encoding function of the first encoder 715a may be represented as *fₙ*, and the third set of outputs 925 may be expressed as *z'pₙ* = *fₙ (p'ₙ).* The third set of outputs 925 may include abstract latent features 927 and physically derived latent features 928. The physically derived latent features 928 may have a second constant value.

At process P906, an inverse transformation function (*T*^{-*1*}) is applied to the third set of outputs 925 to generate a second adjusted set of outputs 930, *zpₙ,* in the first latent space. In some embodiments, the inverse transformation function resets the physically derived latent features 928 from a second constant value to their original values, thereby generating a second adjusted set of outputs 930. For example, the inverse transformation function may be equivalent to effectively copying values of the physically derived latent features 912 of the second set of outputs 910, *zpₘ,* to the physically derived parameters 933 of the second adjusted set of outputs 930, *zpₙ.* The second adjusted set of outputs 930 may be expressed as *_{Z}pₙ = T⁻¹(zpₘ) z'p_{n.}*

At process P907, the second adjusted set of outputs 930 is decoded to a reconstructed second set of inputs 950, *pₘ^{r},* in the second signal space, m, using the second decoder 720b of the second autoencoder model 720. For example, the reconstructed second set of inputs 950 may be pupil images generated by the second decoder 720b. In some embodiments, a goal of the synchronization may be to make the second set of inputs 905 and the reconstructed second set of inputs 950 the same, or minimize the difference between.

At process P908, a cost function that is indicative of a difference between the second set of inputs 905 and the reconstructed second set of inputs 950 is determined. In some embodiments, in addition to the cost function, a second cost function may be determined. The second cost function is indicative of a difference between the first constant value to which the transformed physically derived latent features 913 in the second latent space is set and a second constant value of the physically derived latent features 928 in the first latent space. Another goal of the synchronization process may be to make the first constant value and the second value the same, or minimize the difference between them. The parameters of at least one of the first encoder-decoder pair or the second encoder-decoder pair (e.g., weights or biases) are adjusted to reduce at least one of the cost function or the second cost function. In some embodiments, the first method 900 is repeated iteratively with the same or different second sets of inputs until a synchronization condition is satisfied. For example, the synchronization condition may be satisfied when the cost function (and optionally the second cost function) is minimized, when a threshold number of iterations are performed, or other such condition.

After the iterations are completed, the two autoencoder models are considered to be synchronized. For example, the second latent space of the second autoencoder model 720 is considered to be synchronized with the first latent space of the first autoencoder model 715.

In some embodiments, the encoder of an autoencoder model outputs a distribution over the latent space and not a single latent vector (e.g., this may enforce continuity in the latent space). Accordingly, the encoders may be configured to output a maximum-likelihood estimate latent vector for the distribution they yield (e.g., given a pupil). For example, if the encoder yields a Multivariate-Gaussian over the latent space, then a mean latent vector may be considered as the output of the encoder.

Figure 10A is a flow diagram of a second method 1000 of synchronizing latent spaces of two autoencoder models, in accordance with one or more embodiments. Figure 10B is a block diagram illustrating synchronization of latent spaces of two autoencoder models, in accordance with one or more embodiments. In some embodiments, the second method 1000 is a method of synchronizing a second latent space associated with a second autoencoder model 720 with the first latent space of the first autoencoder model 715. At process P1001, a second set of inputs 1005 *(pₘ)* are provided to a second encoder 720a associated with the second autoencoder model 720. In some embodiments, the second set of inputs 1005 may include pupil images associated with target locations on one or more substrates, such as substrates 706, other input associated with a pattern on the substrates, features of a semiconductor manufacturing, or metrology process data. In some embodiments, the second set of inputs 1005 may be obtained using a measurement tool such as the second machine 708.

At process P1002, the second set of inputs 1005 are encoded by the second encoder 720a to a second set of outputs 1010 *(zpₘ)* in a second latent space of the second autoencoder model 720. For example, the encoding function of the second encoder 720a may be represented as *fₘ*, where m is indicative of a second lithographic process environment or a second signal space, and the second set of outputs 1010 may be expressed as *zpₘ= fₘ(pₘ).* In some embodiments, the second set of outputs 1010 has a lower dimensionality than the second set of inputs 1005. In some embodiments, the second set of outputs 1010 include different types of features. For example, the second set of outputs 1010 includes abstract latent features 1011 (e.g., θ_{m,1} ... θ_{m,N}) and physically derived latent features 1012 (e.g., θ_{m,N+1} ... θ_{m,M}). In some embodiments, abstract latent features 1011 may be the features whose meaning may be unknown, and physically derived latent features 1012 may include observable features (e.g., semiconductor manufacturing process parameters, such as overlay) that may be related to the second set of inputs 1005.

At process P1003, a transformation function (T) is applied to the second set of outputs 1010 to generate a first adjusted set of outputs 1015 *(z'pₘ),* which may be expressed as *z'pₘ = T(zpₘ)*)*.* In some embodiments, the transformation function sets the physically derived latent features 1012 to a first constant value, thereby generating transformed physically derived latent features 1013 in the first adjusted set of outputs 1015. For example, the transformation function may set overlay values in the transformed physically derived latent features 1013 to "0", thus the domain-transfer between the latent spaces would be performed on "0" overlay pupils.

At process P1004, the first adjusted set of outputs 1015 is decoded to a first reconstructed second set of inputs 1055 *(pₘ^{r})* using the second decoder 720b of the first autoencoder model 715. For example, decoding function of the second decoder 720b may be represented as *gₘ,* and the first reconstructed second set of inputs 1055 may be expressed as *pₘ^{r}* = *gₘ (z'pₘ).*

At process P1005, the first adjusted set of outputs 1015 is also decoded to a third set of inputs 1020 (*p*'ₙ) using the first decoder 715b of the first autoencoder model 715. For example, decoding function of the first decoder 715b may be represented as *gₙ* in which *n* is indicative of a first lithographic process environment or a first signal space. For example, the newly derived data in the second latent space (e.g., the first adjusted set of outputs 1015, *z'pₘ)* is decoded as an equivalent pupil *p'ₙby* the first decoder 715b (process-translation) to a first signal space, hence *p'ₙ = gₙ (_{Z}'pₘ).*

At process P1006, the third set of inputs 1020 is encoded to a third set of outputs 1025, *z'pₙ,* in the first latent space using the first encoder 715a of the first autoencoder model 715. The encoding function of the first encoder 715a may be represented as *f_{?}*, and the third set of outputs 1025 may be expressed as *z'pₙ =fₙ* (*p'ₙ*)*.* The third set of outputs 1025 may include abstract latent features 1027 and physically derived latent features 1028. The physically derived latent features 1028 may have a second constant value.

At process P1007, the third set of outputs 1025 is decoded to a second reconstructed second set of inputs 1050, *p'ₘ^{r},* in the second signal space, m, using the second decoder 720b of the second autoencoder model 720. The second reconstructed second set of inputs 1050 may be expressed *as p'ₘ^{r}* = *gₘ (z'pₙ).* For example, the second reconstructed second set of inputs 1050 may be pupil images generated by the second decoder 720b. In some embodiments, goal of synchronization may be to make the first reconstructed second set of inputs 1055 and the second reconstructed second set of inputs 1050 the same, or minimize the difference between them.

At process P1008, a cost function that is indicative of a difference between the first reconstructed second set of inputs 1055 and the second reconstructed second set of inputs 1050 is determined. The parameters of at least one of the first encoder-decoder pair or the second encoder-decoder pair (e.g., weights or biases) are adjusted to reduce the cost function. In some embodiments, the second method 1000 is repeated iteratively with the same or different second sets of inputs until a synchronization condition is satisfied. For example, the synchronization condition may be satisfied when the cost function is minimized, when a threshold number of iterations are performed, or other such condition.

After the iterations are completed, the two autoencoder models are considered to be synchronized. For example, the second latent space of the second autoencoder model 720 is considered to be synchronized with the first latent space of the first autoencoder model 715.

In some embodiments, by not using the inverse transformation function of the first method 900 (e.g., which may result in changing of the gradients of the autoencoder models significantly or quickly) the second method 1000 may overcome any problem or inefficiencies that may arise due to the use of the inverse transformation function.

Note that the above synchronization methods, may consider the abstract latent features (and not the physically derived latent features) to perform the synchronization process on. The other features (e.g., the physically derived latent features) may be set to meaningful values depending on what physical quantity they represent. For instance, consider an example in which two features of the latent vector represent a pupil's overlay, and the remaining features are abstract. Then the process would enforce cycle consistency on the abstract latent features, while setting the overlay values to "0," as described above. Effectively the latent space may learn to have the same amount of information in other asymmetries and extra parameters, orthogonal to overlay.

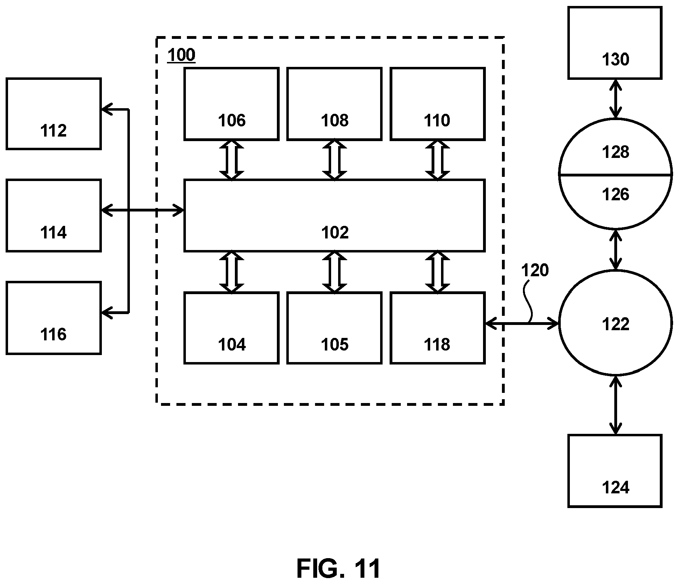

Figure 11 is a block diagram that illustrates a computer system 100 that can perform and/or assist in implementing the methods, flows, systems, or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" or "machine-readable" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

Further embodiments of the computer readable medium, method and apparatus are disclosed in the subsequent list of numbered clauses:
1. A non-transitory computer-readable medium having instructions that, when executed by a computer, cause the computer to execute a method for synchronizing a first machine learning model with a second machine learning model to facilitate parameter prediction, the method comprising:
   obtaining a first autoencoder model that is trained to encode a first set of inputs associated with a first lithographic process environment to a first latent space, wherein the first latent space includes a first set of outputs that has a lower dimensionality than the first set of inputs;
   obtaining a prediction model that is trained using reference data associated with the first latent space to predict one or more parameters associated with a lithographic process;
   obtaining a second autoencoder model that is trained to encode a second set of inputs associated with a second lithographic process environment to a second latent space, wherein the second latent space includes a second set of outputs that has a lower dimensionality than the second set of inputs; and
   synchronizing the second latent space with the first latent space to further train the second autoencoder model to facilitate parameter estimation using the prediction model.
2. The computer-readable medium of clause 1, wherein the first lithographic process environment is representative of a first apparatus configured to obtain measurement data associated with a first substrate having a first target pattern, and the second lithographic process environment is representative of a second apparatus configured to obtain measurement data associated with a second substrate having a second target pattern.
3. The computer-readable medium of clause 2, wherein the first target pattern and the second target pattern are the same.
4. The computer-readable medium of clause 2, wherein the first target pattern and the second target pattern are different.
5. The computer-readable medium of clause 1, wherein the first lithographic process environment is representative of a first time at which measurement data associated with a first substrate is obtained by an apparatus, and the second lithographic process environment is representative of a second time at which measurement data associated with a second substrate is obtained by the apparatus.
6. The computer-readable medium of clause 1, wherein the first lithographic process environment is representative of a first layer of a target pattern printed on a substrate for which measurement data is obtained, and the second lithographic process environment is representative of a second layer of the target pattern for which measurement data is obtained.
7. The computer-readable medium of clause 1, wherein synchronizing the second latent space with the first latent space includes:
   (i) obtaining, using the first autoencoder model, a third set of inputs based on the second set of outputs in the second latent space;
   (ii) obtaining, using the second autoencoder model, a reconstructed second set of inputs based on a third set of outputs in the first latent space, the third set of outputs generated by the first autoencoder model;
   (iii) determining a cost function that is indicative of a difference between the second set of inputs and the reconstructed second set of inputs; and
      performing steps (i)-(iii) iteratively until a synchronization condition is satisfied.
8. The computer-readable medium of clause 7, wherein obtaining the third set of inputs includes:
   applying a transformation function to the second set of outputs to generate a first adjusted set of outputs.
9. The computer-readable medium of clause 8, wherein the transformation function sets a subset of outputs from the second set of outputs to a first constant value.
10. The computer-readable medium of clause 8, wherein the subset of outputs includes physically derived parameters associated with a substrate being measured.
11. The computer-readable medium of clause 8 further comprising:
   decoding, using the first autoencoder model, the first adjusted set of outputs to the third set of inputs.
12. The computer-readable medium of clause 7, wherein obtaining the reconstructed second set of inputs includes:
   encoding, using the first autoencoder model, the third set of inputs to the third set of outputs in the first latent space.
13. The computer-readable medium of clause 12 further comprising:
   applying a transformation function to the third set of outputs to generate a second adjusted set of outputs.
14. The computer-readable medium of clause 13, wherein the transformation function is an inverse transformation function, wherein the inverse transformation function sets a subset of outputs from the third set of outputs to a second set of values from a second constant value.
15. The computer-readable medium of clause 13 further comprising:
   decoding, using the second autoencoder model, the second adjusted set of outputs to the reconstructed second set of inputs.
16. The computer-readable medium of clause 7, wherein determining the cost function further includes:
   determining a second cost function that is indicative of a difference between a first constant value and a second constant value, wherein the first constant value is of a subset of outputs from the second set of outputs, and wherein the second constant value is of a subset of outputs from the third set of outputs.
17. The computer-readable medium of clause 16, wherein performing the steps (i)-(iii) iteratively includes:
   adjusting parameters of at least one of the first autoencoder model or the second autoencoder model to reduce at least one of the cost function or the second cost function; and
   performing steps (i)-(iii) iteratively until at least one of the cost function or the second cost function is minimized.
18. The computer-readable medium of clause 1, wherein synchronizing the second latent space with the first latent space includes:
   (i) encoding, using the second autoencoder model, the second set of inputs to the second set of outputs in the second latent space;
   (ii) decoding, using the first autoencoder model, the second set of outputs to a third set of inputs;
   (iii) encoding, using the first autoencoder model, the third set of inputs to a third set of outputs in the first latent space; and
   (iv) decoding, using the second autoencoder model, the third set of outputs to a reconstructed second set of inputs.
19. The computer-readable medium of clause 16 further comprising:
   determining a cost function that is indicative of a difference between the second set of inputs and the reconstructed second set of inputs; and
   performing steps (i)-(iv) iteratively until the cost function is minimized.
20. The computer-readable medium of clause 1, wherein synchronizing the second latent space with the first latent space includes:
   (i) applying a transformation function to the second set of outputs to generate a first adjusted set of outputs, wherein the transformation function sets a subset of outputs from the second set of outputs to a first constant value;
   (ii) obtaining, using the first autoencoder model, a third set of inputs based on the first adjusted set of outputs in the second latent space;
   (iii) obtaining, using the second autoencoder model, a first reconstructed second set of inputs based on a third set of outputs in the first latent space, the third set of outputs generated by the first autoencoder model;
   (iv) obtaining, using the second autoencoder model, a second reconstructed second set of inputs based on the first adjusted set of outputs in the first latent space;
   (v) determining a cost function that is indicative of a difference between the first reconstructed second set of inputs and the second reconstructed second set of inputs; and
      performing steps (i)-(v) iteratively until a synchronization condition is satisfied.
21. The computer-readable medium of clause 18, wherein the subset of outputs includes physically derived parameters associated with a substrate being measured.
22. The computer-readable medium of clause 18, wherein obtaining the third set of inputs includes:
   decoding, using the first autoencoder model, the first adjusted set of outputs to the third set of inputs.
23. The computer-readable medium of clause 18, wherein obtaining the first reconstructed second set of inputs includes:
   encoding, using the first autoencoder model, the third set of inputs to the third set of outputs in the first latent space; and
   decoding, using the second autoencoder model, the third set of outputs to the first reconstructed second set of inputs.
24. The computer-readable medium of clause 18, wherein obtaining the second reconstructed second set of inputs includes:
   decoding, using the second autoencoder model, the first adjusted set of outputs to the second reconstructed second set of inputs.
25. The computer-readable medium of clause 18, wherein performing the steps (i)-(v) iteratively includes:
   adjusting parameters of at least one of the first autoencoder model or the second autoencoder model to reduce the cost function; and
   performing steps (i)-(v) iteratively until the cost function is minimized.
26. The computer-readable medium of clause 1, wherein the first set of inputs or the second set of inputs includes pupil data that is representative of parameters associated with a pattern printed on a substrate.
27. The computer-readable medium of clause 1 further comprising:
   providing a set of inputs to the second autoencoder model to obtain a set of outputs in the second latent space; and
   providing the set of outputs to the prediction model to estimate a parameter based on the set of outputs in the second latent.
28. The computer-readable medium of clause 27, wherein the parameter is one of a plurality of semiconductor manufacturing process parameters.
29. The computer-readable medium of clause 28, wherein the parameter includes overlay.
30. The computer-readable medium of clause 27 further comprising:
   adjusting one or more semiconductor manufacturing process parameters based on the parameter.
31. The computer-readable medium of clause 30 further comprising:
   performing a patterning step based on the one or more semiconductor manufacturing process parameters to print a pattern on a substrate.
32. A method for synchronizing a first machine learning model with a second machine learning model to facilitate parameter prediction, the method comprising:
   obtaining a first autoencoder model that is trained to encode a first set of inputs associated with a first lithographic process environment to a first latent space, wherein the first latent space includes a first set of outputs that has a lower dimensionality than the first set of inputs;
   obtaining a prediction model that is trained using reference data associated with the first latent space to predict one or more parameters associated with a lithographic process;
   obtaining a second autoencoder model that is trained to encode a second set of inputs associated with a second lithographic process environment to a second latent space, wherein the second latent space includes a second set of outputs that has a lower dimensionality than the second set of inputs; and synchronizing the second latent space with the first latent space to further train the second autoencoder model to facilitate parameter estimation using the prediction model.
33. An apparatus for synchronizing a first machine learning model with a second machine learning model to facilitate parameter prediction, the apparatus comprising:
   a memory storing a set of instructions; and
   a processor configured to execute the set of instructions to cause the apparatus to perform a method of:
      obtaining a first autoencoder model that is trained to encode a first set of inputs associated with a first lithographic process environment to a first latent space, wherein the first latent space includes a first set of outputs that has a lower dimensionality than the first set of inputs;
      obtaining a prediction model that is trained using reference data associated with the first latent space to predict one or more parameters associated with a lithographic process;
      obtaining a second autoencoder model that is trained to encode a second set of inputs associated with a second lithographic process environment to a second latent space, wherein the second latent space includes a second set of outputs that has a lower dimensionality than the second set of inputs; and
      synchronizing the second latent space with the first latent space to further train the second autoencoder model to facilitate parameter estimation using the prediction model.

While the concepts disclosed herein may be used for imaging on a substrate such as a silicon wafer, it shall be understood that the disclosed concepts may be used with any type of lithographic imaging systems, e.g., those used for imaging on substrates other than silicon wafers, and/or metrology systems. In addition, the combination and sub-combinations of disclosed elements may comprise separate embodiments. For example, predicting a complex electric field image and determining a metrology metric such as overlay may be performed by the same parameterized model and/or different parameterized models. These features may comprise separate embodiments, and/or these features may be used together in the same embodiment.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g., a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g., a disk) or an intangible carrier medium (e.g., a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g., within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

To the extent certain U.S. patents, U.S. patent applications, or other materials (e.g., articles) have been incorporated by reference, the text of such U.S. patents, U.S. patent applications, and other materials is only incorporated by reference to the extent that no conflict exists between such material and the statements and drawings set forth herein. In the event of such conflict, any such conflicting text in such incorporated by reference U.S. patents, U.S. patent applications, and other materials is specifically not incorporated by reference herein.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

## Claims

1. A method for synchronizing a first machine learning model with a second machine learning model to facilitate parameter prediction, the method comprising:
obtaining a first autoencoder model that is trained to encode a first set of inputs associated with a first lithographic process environment to a first latent space, wherein the first latent space includes a first set of outputs that has a lower dimensionality than the first set of inputs;
obtaining a prediction model that is trained using reference data associated with the first latent space to predict one or more parameters associated with a lithographic process;
obtaining a second autoencoder model that is trained to encode a second set of inputs associated with a second lithographic process environment to a second latent space, wherein the second latent space includes a second set of outputs that has a lower dimensionality than the second set of inputs; and
synchronizing the second latent space with the first latent space to further train the second autoencoder model to facilitate parameter estimation using the prediction model.

2. The method of claim 1, wherein the first lithographic process environment is representative of a first apparatus configured to obtain measurement data associated with a first substrate having a first target pattern, and the second lithographic process environment is representative of a second apparatus configured to obtain measurement data associated with a second substrate having a second target pattern.

3. The method of claim 1, wherein the first lithographic process environment is representative of a first time at which measurement data associated with a first substrate is obtained by an apparatus, and the second lithographic process environment is representative of a second time at which measurement data associated with a second substrate is obtained by the apparatus.

4. The method of claim 1, wherein the first lithographic process environment is representative of a first layer of a target pattern printed on a substrate for which measurement data is obtained, and the second lithographic process environment is representative of a second layer of the target pattern for which measurement data is obtained.

5. The method of claim 1, wherein synchronizing the second latent space with the first latent space includes:
(i) obtaining, using the first autoencoder model, a third set of inputs based on the second set of outputs in the second latent space;
(ii) obtaining, using the second autoencoder model, a reconstructed second set of inputs based on a third set of outputs in the first latent space, the third set of outputs generated by the first autoencoder model;
(iii) determining a cost function that is indicative of a difference between the second set of inputs and the reconstructed second set of inputs; and
performing steps (i)-(iii) iteratively until a synchronization condition is satisfied.

6. The method of claim 1, wherein synchronizing the second latent space with the first latent space includes:
(i) encoding, using the second autoencoder model, the second set of inputs to the second set of outputs in the second latent space;
(ii) decoding, using the first autoencoder model, the second set of outputs to a third set of inputs;
(iii) encoding, using the first autoencoder model, the third set of inputs to a third set of outputs in the first latent space; and
(iv) decoding, using the second autoencoder model, the third set of outputs to a reconstructed second set of inputs.

7. The method of claim 6, wherein the subset of outputs includes physically derived parameters associated with a substrate being measured.

8. The method of claim 1, wherein synchronizing the second latent space with the first latent space includes:
(i) applying a transformation function to the second set of outputs to generate a first adjusted set of outputs, wherein the transformation function sets a subset of outputs from the second set of outputs to a first constant value;
(ii) obtaining, using the first autoencoder model, a third set of inputs based on the first adjusted set of outputs in the second latent space;
(iii) obtaining, using the second autoencoder model, a first reconstructed second set of inputs based on a third set of outputs in the first latent space, the third set of outputs generated by the first autoencoder model;
(iv) obtaining, using the second autoencoder model, a second reconstructed second set of inputs based on the first adjusted set of outputs in the first latent space;
(v) determining a cost function that is indicative of a difference between the first reconstructed second set of inputs and the second reconstructed second set of inputs; and
performing steps (i)-(v) iteratively until a synchronization condition is satisfied.

9. The method of claim 6, wherein obtaining the second reconstructed second set of inputs includes:
decoding, using the second autoencoder model, the first adjusted set of outputs to the second reconstructed second set of inputs.

10. The method of claim 6, wherein performing the steps (i)-(v) iteratively includes:
adjusting parameters of at least one of the first autoencoder model or the second autoencoder model to reduce the cost function; and
performing steps (i)-(v) iteratively until the cost function is minimized.

11. The method of claim 1, wherein the first set of inputs or the second set of inputs includes pupil data that is representative of parameters associated with a pattern printed on a substrate.

12. The method of claim 1 further comprising:
providing a set of inputs to the second autoencoder model to obtain a set of outputs in the second latent space; and
providing the set of outputs to the prediction model to estimate a parameter based on the set of outputs in the second latent.

13. The method of claim 12, wherein the parameter is one of a plurality of semiconductor manufacturing process parameters.

14. A non-transitory computer-readable medium having instructions that, when executed by a computer, cause the computer to execute a method for synchronizing a first machine learning model with a second machine learning model to facilitate parameter prediction, the method comprising:
obtaining a first autoencoder model that is trained to encode a first set of inputs associated with a first lithographic process environment to a first latent space, wherein the first latent space includes a first set of outputs that has a lower dimensionality than the first set of inputs;
obtaining a prediction model that is trained using reference data associated with the first latent space to predict one or more parameters associated with a lithographic process;
obtaining a second autoencoder model that is trained to encode a second set of inputs associated with a second lithographic process environment to a second latent space, wherein the second latent space includes a second set of outputs that has a lower dimensionality than the second set of inputs; and
synchronizing the second latent space with the first latent space to further train the second autoencoder model to facilitate parameter estimation using the prediction model.

15. An apparatus for synchronizing a first machine learning model with a second machine learning model to facilitate parameter prediction, the apparatus comprising:
a memory storing a set of instructions; and
a processor configured to execute the set of instructions to cause the apparatus to perform a method of:
obtaining a first autoencoder model that is trained to encode a first set of inputs associated with a first lithographic process environment to a first latent space, wherein the first latent space includes a first set of outputs that has a lower dimensionality than the first set of inputs;
obtaining a prediction model that is trained using reference data associated with the first latent space to predict one or more parameters associated with a lithographic process;
obtaining a second autoencoder model that is trained to encode a second set of inputs associated with a second lithographic process environment to a second latent space, wherein the second latent space includes a second set of outputs that has a lower dimensionality than the second set of inputs; and
synchronizing the second latent space with the first latent space to further train the second autoencoder model to facilitate parameter estimation using the prediction model.
